# EUROPEAN PATENT APPLICATION

(11) **EP 0 545 414 A2**
(43) Date of publication of application: **09.06.1993**
(21) Application number: 92120656.1
(22) Date of filing: 03.12.1992
(51) Int. Cl.: H03K 17/14

(54) **Input stage for a digital integrated semiconductor circuit**

(30) Priority: 04.12.1991 DE 4139911
(71) Applicant: TEXAS INSTRUMENTS DEUTSCHLAND GMBH, D-85356 Freising (DE)
(72) Inventor: Seibold, Herrmann, W-8051 Haag, Amper (DE)
(74) Representative: Schwepfinger, Karl-Heinz, Dipl.-Ing.

(57) **Abstract**

An input stage (20) for a digital integrated semiconductor circuit contains bipolar transistors (Q1) and complementary MOS transistors (P1, N1, P2). Between a supply voltage terminal (12) and a ground terminal there is a series circuit of the collector-emitter path of a bipolar transistor (Q1) and the source-drain paths of two complementary MOS transistors (P1, N1). To the base of the bipolar transistor (Q1) a voltage is applied which is derived from a supply voltage (Vcc) fluctuating between an upper limit value and a lower limit value. The gate terminals of the complementary MOS transistors (P1, N1) are connected jointly to the input terminal (14). The voltage applied to the base of the bipolar transistor (Q1) is regulated.

## Description

The invention relates to an input stage for a digital integrated semiconductor circuit containing bipolar transistors and complementary MOS transistors, comprising a series circuit lying between a supply voltage terminal and a ground terminal and consisting of the collector-emitter path of a bipolar transistor and the source-drain paths of two complementary MOS transistors, a voltage derived from the supply voltage fluctuating between an upper limit value and a lower limit value being applied to the base of the bipolar transistor and the gate terminals of the complementary MOS transistors being jointly connected to an input terminal.

An input stage of this type is for example used in the bus driver circuit of the type ABT 16244 made by the Texas Instruments Company. The combination of bipolar transistors and complementary MOS transistors is used in such input stages in order to utilize the advantages of the two types of transistors. The bipolar transistors give a high switching speed and the MOS transistors can be controlled almost completely currentless.

The known input stage has the disadvantage that its behaviour is influenced by fluctuations of the supply voltage. This applies in particular to the transit delay, i.e. to the time which elapses until a level change occurring at an input appears at the output. The transit delay varies with fluctuations of the supply voltage; in particular, when the supply voltage drops a different transit delay arises on a level change of the input signal from a low value to a high value compared with change from a high value to a low value. This also applies to the direct current takeup of the input stage which when the supply voltage rises assumes inadmissibly high values.

The invention is based on the problem of providing an input stage of the type indicated at the beginning, wtih which fluctuations of the supply voltage do not have any disadvantages effects on the transit delay and on the direct current behaviour.

According to the invention this problem is solved in that the voltage applied to the base of the bipolar transistor is regulated.

An advantageous further development of the invention resides in the voltage applied to the base of the bipolar transistor being regulated to a value which corresponds to the lower limit value of the fluctuation range of the supply voltage.

The invention will now be explained by way of example with the aid of the drawings, wherein:
Fig. 1 shows a known input stage and
Fig.2 shows an input stage according to the invention.

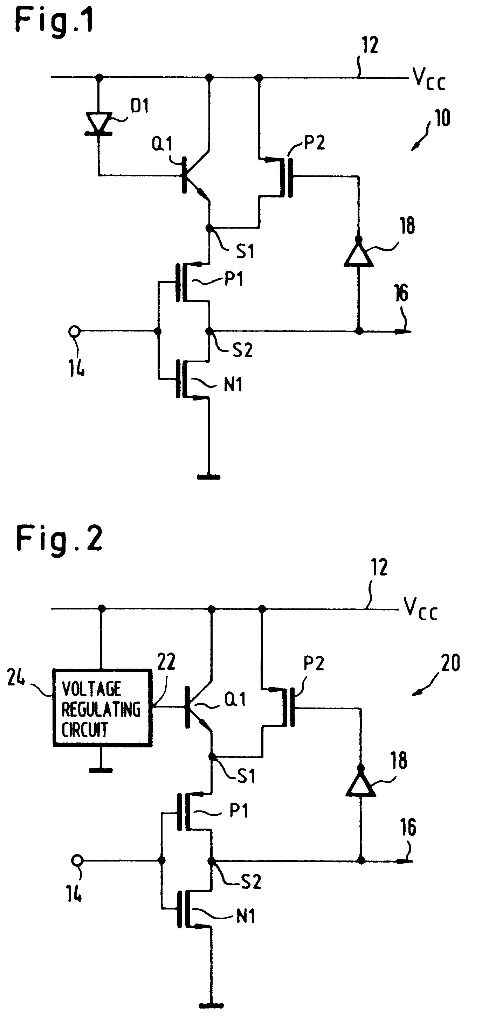

The input stage 10 is operated with a supply voltage Vcc = V at the supply voltage line 12. The input stage 10 is so configured that it operates with so called ITL levels, which means that its input switching threshold is at 1.5V. This switching threshold is set by the series circuit comprising the collect-emitter path of a bipolar transistor Q1 and the source-drain paths of the P-channel MOS transistor P1 and the N-channel MOS transistor N1. Due to the connection of the base of the transistor Q1 via a diode D1 to the supply voltage line 12, at the circuit point S1 a voltage 3 V and 4V arises when the fluctuations of the supply voltage Vcc are taken into account, these extending from about 4.5 V to 5.5 V. The voltage at the circuit point S1 is in every case 2 U_{BE} less than the supply voltage Vcc, U_{BE} being the known base-emitter voltage drop at a diode, which is about 0.7 V. By a suitable choice of the geometric magnitudes of the zones forming the MOS transistors P1 and N1 in the integrated semiconductor circuit it is possible to achieve that the switching threshold lies at the prescribed value of 1.5 V, i.e. when the voltage at the input terminal 14 which is connected to the interconnected gate terminals of the MOS transistors P1 and N1 exceeds the voltage value 1.5 V, the voltage at the circuit point S2 forming the output of the input stage changes from a high voltage value to a low voltage value. It is of no consequence here that the input stage in the embodiment illustrated in Fig. 1 has an inverting effect with respect to the voltage at the input terminal 14 and the voltage at the circuit point S2 because by circuit components which are not illustrated in Fig. 1 and which are connected to the output terminal 16 the voltage level can readily be used either in the inverted form or in the non-inverted form by another inversion.

A negator 18 connected to the circuit point S2 and a P-channel MOS transistor P2 are used to ensure that the full voltage swing up to the supply voltage Vcc at the circuit point S1 can be utilized when the voltage at the circuit point S2 assumes a low value. The input stage 10 of Fig. 1 has the disadvantage that the switching threshold at which the input stage reacts to a level change at the input terminal 14 also varies with a variation of the supply voltage Vcc. A lowering of the supply voltage Vcc and thus a reduction of the switching threshold leads to an increase in the difference of the transit delay with which a change of the voltage at the input terminal 14 from a low value to a high value on the one hand and from a high value to a low value on the other hand manifests itself at the output terminal 16. The desired ideal case in which a level change at the input terminal 14 is always reproduced at the output terminal 16 after the same transit delay independently of the direction of the change can no longer be achieved. This disadvantage is noticeable in particular when the supply voltage Vcc is lowered.

A further disadvantage of the input stage 10 of Fig. 1 resides in that on shifting the switching threshold to a higher value due to a corresponding increase of the supply voltage Vcc an input signal which is applied to the input terminal 14 and which has a voltage of over 1.5 V, i.e. represents a high signal level, may possibly no longer lead to a complete blocking of the MOS transistor P1 so that in the series circuit comprising the transistors Q1, P1 and N1 in this case a current which is no longer negligible flows and the input stage no longer meets the requirements made when using said stage in the aforementioned bus driver. Although this disadvantage could be diminished by corresponding dimensioning of the MOS transistors P1 and N1, this would be at the expense of the switching speed of the input stage.

In so far as the input stage of Fig. 2 corresponds to the input stage of Fig. 1, the same reference numerals are used for the same components. As can be seen, in the input stage of Fig. 2 the output 20 of a voltage regulating circuit 22 is connected to the base of the bipolar transistor Q1, said circuit generating a regulated voltage from the supply voltage Vcc at the supply voltage line 12. If it is assumed that the supply voltage Vcc can take on values between 4.5 V and 5.5 V, then the voltage regulating circuit 22 is so configured that it furnishes a regulated voltage of 4.5 V at its output 20, i.e. a voltage which corresponds to the lower limit value of the fluctuation range of the supply voltage Vcc. Assuming the base voltage of the transistor Q1 is 4.5 V, at its emitter a constant voltage of about 3.7 V results. Since this voltage at the circuit point S1 is constant, by a corresponding dimensioning of the MOS transistors P1 and N1 the switching threshold of the input stage can be fixed exactly to the desired value of 1.5 V.

If it is assumed that the voltage 0 V is present at the input 14, the MOS transistor N1 is non-conductive and the MOS transistor P1 is in a conductive state. Via the negator 18 the MOS transistor P2 is thereby put into the conductive state so that the voltage at the circuit point S1 is increased to the value of the supply voltage Vcc.

Now, when the voltage at the input 14 increases and exceeds the switching threshold of 1.5 V, the MOS transistor N1 becomes conductive and the MOS transistor P1 non-conductive. This means that the voltage at the circuit point S2 and thus at the output 16 drops to a low value which corresponds almost to ground potential. Due to the ground potential at the output 16, via the negator 18 the MOS transistor P2 is also rendered non-conductive so that at the circuit point S1 the voltage of about 3.7 V set by the regulated base voltage of the transistor Q1 arises, as has already been explained.

A rise of the supply voltage Vcc to the upper limit of its fluctuation range does not result in the flowing of an increased current through the series circuit of the transistors Q1, P1 and N1 as in the input stage of Fig. 1, since under all voltage conditions at the input 14 one of the MOS transistors N1 and P1 is non-conductive. Moreover, a lowering of the supply voltage Vcc to the lower limit value of 4.5 V no longer has any disadvantageous effects on the transit delay of the input stage.

In Fig. 2 an input stage is shown with which a voltage regulating circuit 22 is associated. When this input stage is used for example in an 8-bit bus driver it is present in the latter a total of eight times, the voltage regulating circuit 22 being however required only once and furnishing the base bias for the eight bipolar transistors Q1.

## Claims

1. An input stage for a semiconductor circuit containing transistors and complementary transistors, comprising a series circuit lying between a supply voltage terminal and a ground terminal and including the collector-emitter path of the transistor and the source-drain paths of the complementary transistors, wherein a voltage, derived from the supply voltage fluctuating between an upper limit value and a lower limit value, being applied to the base of the transistor and the gate terminals of the complementary transistors being jointly connected to an input terminal, and further wherein the voltage applied to the base of the transistor is regulated.

2. An input stage according to claim 1, wherein the voltage applied to the base of the transistor is regulated to a value which corresponds to the lower limit value of the fluctuation range of the supply voltage.

3. An input stage according to claim 1 or claim 2, wherein the semiconductor circuit comprises a digital integrated semiconductor circuit.

4. An input stage according to any of claims 1 to 3, wherein the transistors comprise bipolar transistors.

5. An input stage according to any preceding claim, wherein the complementary transistors comprise complementary MOS transistors.
